# EUROPÄISCHE PATENTSCHRIFT

(11) **EP 1 040 560 B1**
(45) Veröffentlichungstag und Bekanntmachung des Hinweises auf die Patenterteilung: **24.07.2002**
(21) Anmeldenummer: 98966192.1
(22) Anmeldetag: 04.12.1998
(51) Int. Cl.: H02M 7/00

(54) **SELBSTGEFÜHRTER STROMRICHTER EINES SPANNUNGSEINPRÄGENDEN UMRICHTERS MIT N HOCHLEISTUNGS-MODULEN**
SELF-COMMUTATED POWER CONVERTER OF A VOLTAGE-IMPRESSING CONVERTER WITH N HIGH-POWER MODULES
REDRESSEUR A COMMUTATION AUTOMATIQUE D'UN CHANGEUR DE FREQUENCE COMPRENANT N MODULES PERFORMANTS

(30) Priorität: 17.12.1997 DE 19756250
(43) Veröffentlichungstag der Anmeldung: 04.10.2000
(73) Patentinhaber: SIEMENS AKTIENGESELLSCHAFT, 80333 München (DE)
(72) Erfinder: PFAUSER, Anton, D-96178 Pommersfelden (DE)
(86) Internationale Anmeldenummer: DE9803570
(87) Internationale Veröffentlichungsnummer: WO9931791

(56) Entgegenhaltungen:
- EP-A- 0 356 991
- EP-A- 0 658 934
- US-A- 4 682 268
- US-A- 5 477 416

## Beschreibung

Die Erfindung bezieht sich auf einen selbstgeführten Stromrichter eines spannungseinprägenden Umrichters mit n Hochleistungs-Modulen, insbesondere IGBT-Hochleistungs-Modulen.

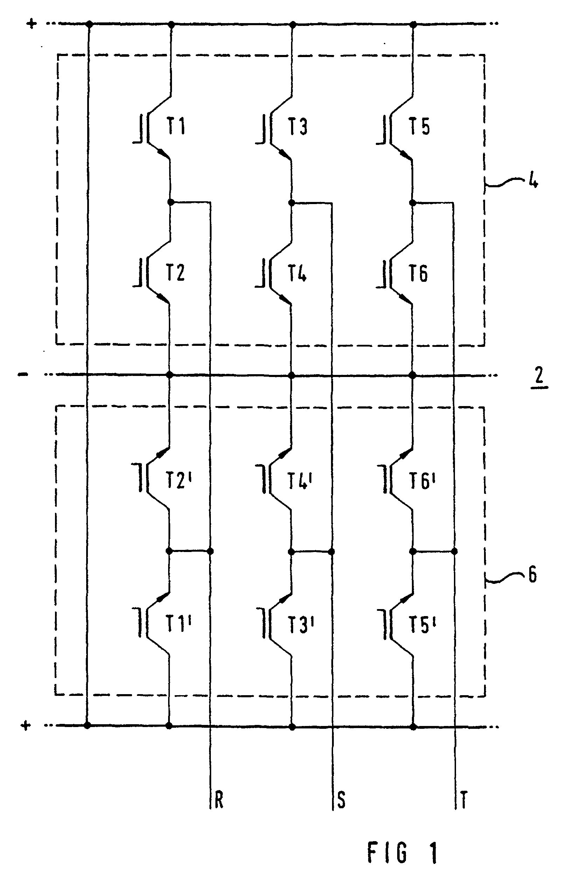

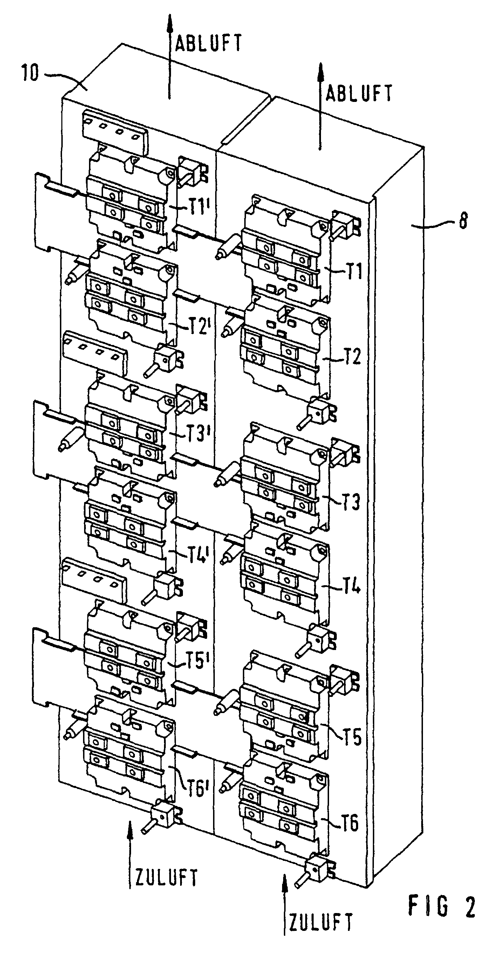

Im Handel sind Spannungszwischenkreis-Umrichter für Drehstromantriebe bis mehreren MW erhältlich, dessen selbstgeführter Stromrichter mehrere Hochleistungs-Module aufweist. Bei diesen Leistungen weist der selbstgeführte Stromrichter zwei Wechselrichter auf, die elektrisch parallel geschaltet sind. In der FIG 1 ist ein Ersatzschaltbild eines derartigen selbstgeführten Stromrichters 2 dargestellt. Die beiden parallel geschalteten Wechselrichter 4 und 6 weisen jeweils als Stromrichterventile IGBT-Hochleistungs-Module T1 bis T6 und T1' bis T6' auf. Die IGBT-Hochleistungs-Module T1 bis T6 des Wechselrichters 4 sind auf einem Kühlkörper 8 angeordnet (FIG 2). Ebenso sind die IGBT-Hochleistungs-Module T1' bis T6' des Wechselrichters 6 auf einem Kühlkörper 10 angeordnet (FIG 2).

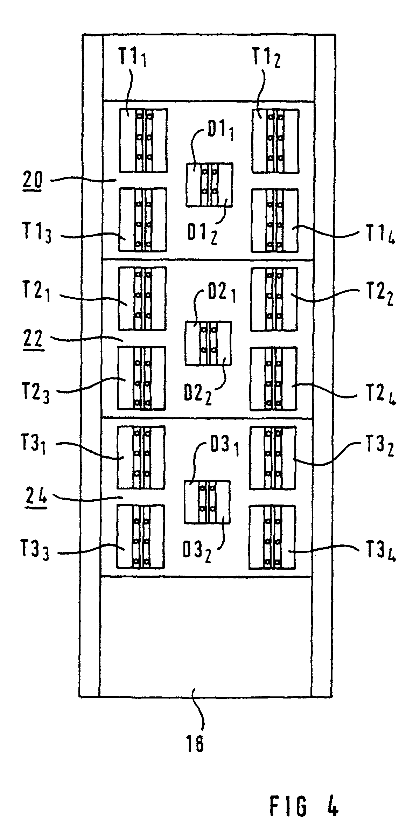

In der FIG 2 sind diese Kühlkörper 8 und 10 mit den zugehörigen IGBT-Hochleistungs-Modulen T1 bis T6 und T1' bis T6' veranschaulicht. Dieser Darstellung ist zu entnehmen, daß die IGTB-Hochleistungs-Module T1 bis T6 bzw. T1' bis T6' entlang der Strömungsrichtung der Kühlluft übereinander angeordnet sind. Der verwendete Kühlkörper ist in der EP 0 658 934 A2, insbesondere in der Figur 4, dieser europäischen Patentanmeldung dargestellt.

Ein Nachteil dieses Aufbaus des Leistungsteils des Wechselrichters 4 bzw. 6 ist der, daß zumindest das oberste Modul T1 bzw. T1' eine erwärmte Kühlluft bekommt. Die am Kühlkörper 8 bzw. 10 einströmende Kühlluft erwärmt sich von IGBT-Modul zu IGBT-Modul. Somit kann die Kühlluft beim obersten Modul T1 bzw. T1' wesentlich weniger Verlustleistung abführen als die Kühlluft beim untersten Modul T6 bzw. T6'. Damit der Wechselrichter 4 bzw. 6 nicht wegen Überhitzung des obersten Moduls T1 bzw. T1' ausfällt, wird die technische Auslegung des selbstgeführten Stromrichters 2 nach dem obersten Modul T1 bzw. T1' ausgelegt. Dadurch kann eine Leistungsreduzierung von 20 % für den selbstgeführten Stromrichter 2 auftreten. Das heißt, daß man ggf. für einen selbstgeführten Hochleistungs-Stromrichter pro Stromrichterventil zwei elektrisch in Reihe geschaltete IGBT-Hochleistungs-Module vorgesehen werden müssen. Dadurch würde sich das aufgezeigte Problem bei einer in der FIG 2 dargestellten Anordnung noch verstärken, wodurch mit einem weiteren Anstieg der Leistungsreduzierung zu rechnen wäre. Das heißt, der Wirkungsgrad würde sich weiter verschlechtern.

Diese zusätzlichen IGBT-Module beeinflussen außerdem die Baugröße, das Gewicht und die Kosten des selbstgeführten Stromrichters und damit auch des spannungseinprägenden Umrichters. Außerdem können bei einer Reihenschaltung von wenigstens zwei Modulen innerhalb eines derartigen Stromrichterzweiges schon geringste Unterschiede in den Schaltzeiten zu unsymmetrischen Spannungsaufteilungen führen. Derartige Spannungsunterschiede können durch eine zusätzliche Maßnahme in der Ansteuerung verhindert werden. Dieser zusätzliche Aufwand kann vermieden werden, wenn die Netzkondensatorspannung durch eine Mittelanzapfung zweigeteilt wird, so daß sich zu den beiden Potentialen Plus und Minus das Potential Null ergibt. Durch Anbindung des Nullpotentials über je zwei zusätzliche Mittelpunktsdioden jedes Zweigpaares entsteht ein sogenannter Dreipunkt-Stromrichter, der selbstgeführt ist.

Im Aufsatz "Transistorwechselrichter für Nahverkehrstriebfahrzeuge", abgedruckt in der DE-Zeitschrift "eb - Elektrische Bahnen", Band 91, 1993, Nr. 11, Seiten 341 bis 347, ist als selbstgeführter Stromrichter ein derartiger Dreipunkt-Wechselrichter dargestellt. Ein derartiger Dreipunkt-Wechselrichter verwendet pro Wechselrichterzweig die gleiche Anzahl an Modulen wie ein Zweipunkt-Wechselrichter mit jeweils zwei Modulen pro Stromrichterventil, bietet jedoch wesentliche Vorteile, die in Kapitel 3.1 dieses Aufsatzes angegeben sind.

Das Patentdokument US-A-4,682,268 offenbart Halbleitermodule, die mit Kühlkörper verbunden sind und wobei eine Trennwand die Module von den Kühlkörpern trennt.

Handelsübliche IGBT-Module werden als vergossene Bausteine geliefert, die den eigentlichen IGBT und eine antiparallele Freilaufdiode enthalten. Durch den isolierten Aufbau der Halbleiter innerhalb des Moduls können die IGBT-Module des Dreipunkt-Wechselrichters auf einen gemeinsamen Kühlkörper ohne weitere Maßnahmen zur Potentialtrennung montiert werden. Die Kühlluft bestreicht die Unterseite des Kühlkörpers und kommt mit den elektrischen Bauteilen auf der Oberseite nicht in Berührung. Bei dieser Anordnung sind nur noch drei IGBT-Module entlang der Strömungsrichtung der Kühlluft nebeneinander angeordnet. Der Nachteil bei dieser Anordnung liegt darin, daß bei Defekt einer Wechselrichterphase der Aufwand für den Austausch eines oder mehrerer Module recht hoch ist.

Der Erfindung liegt nun die Aufgabe zugrunde, einen selbstgeführten Stromrichter mit n Hochleistungs-Modulen anzugeben, der die zuvor genannten Nachteile nicht mehr aufweist.

Diese Aufgabe wird erfindungsgemäß mit den Merkmalen des Anspruchs 1 gelöst. Bei dieser erfindungsgemäßen Ausführungsform des selbstgeführten Stromrichters sind die Hochleistungs-Module einer Phase mit einem Phasen-Kühlkörper lösbar verbunden, wobei diese Phasen-Kühlkörper lösbar mit einer Trennwand des Stromrichters verknüpft sind, durch deren Aussparungen die Kühlrippen eines jeden Phasen-Kühlkörpers in einen Belüftungsraum ragen. Dadurch können bei Defekten in den Stromrichterzweigen (Phasen) diese defekten Phasen-Bausteine relativ einfach ausgebaut werden. Außerdem wird mittels der Trennwand dafür gesorgt, daß die Kühlluft nur die Kühlrippen der Phasen-Kühlkörper bestreicht und mit den elektrischen Bauteilen nicht in Berührung kommt (hohe Schutzart für den Leistungselektronikbereich).

Dadurch, daß die Kühlrippen der einzelnen Phasen-Kühlkörper waagerecht im Belüftungsraum verlaufen und ein Abluftkanal vorgesehen ist, der derart ausgestaltet ist, daß die Kühlluft des Belüftungsraumes jeweils beidseitig seitlich der Phasen-Kühlkörper zwischen den Kühlrippen in den Abluftkanal strömt, werden alle IGBT-Hochleistungs-Module gleichmäßig gekühlt, so daß die Leistungsfähigkeit jedes IGBT-Moduls voll ausgenutzt werden kann.

Durch diese Ausgestaltung der Phasen-Bausteine können in Abhängigkeit eines geforderten Laststromes pro Phasen-Kühlkörper bis zu zwölf Hochleistungs-Module angeordnet werden, die derart gekühlt werden, daß keine Leistungsreduzierung in Kauf genommen werden muß. Gegenüber einem herkömmlichen Aufbau eines selbstgeführten Stromrichters mit derselben Modulzahl verbessert sich die Kühlung wesentlich, wobei ebenfalls bei der Baugröße, beim Gewicht und somit bei den Kosten gespart wird.

Durch die Anordnung der Kühlrippen der einzelnen Phasen-Kühlkörper in einem Belüftungsraum und die Verwendung eines Abluftkanals wird erreicht, daß alle Hochleistungs-Module annähernd gleich gekühlt werden können, so daß die im Handel erhältlichen IGBT-Hochleistungs-Module (1200 A/3300 V) leistungsmäßig voll ausgenutzt werden können.

Vorteilhafte Ausgestaltungen der Phasen-Kühlkörper, des Abluftkanals und des Belüftungsraumes sind den abhängigen Ansprüchen 2 bis 10 zu entnehmen.

Zur näheren Erläuterung der Erfindung wird auf die Zeichnung Bezug genommen, in der mehrere Ausführungsformen des erfindungsgemäßen selbstgeführten Stromrichters eines spannungseinprägenden Umrichters schematisch veranschaulicht sind.
- FIG 1: zeigt ein Ersatzschaubild eines bekannten selbstgeführten Stromrichters, wobei in der
- FIG 2: dessen Realisierung veranschaulicht ist, in der
- FIG 3: ist ein Ersatzschaltbild eines selbstgeführten Hochleistungs-Stromrichters dargestellt, wobei in den
- FIG 4 - 6: dessen stufenweise Realisierung veranschaulicht sind, und die
- FIG 7: zeigt einen Ausschnitt des erfindungsgemäßen selbstgeführten Stromrichters nach FIG 4.

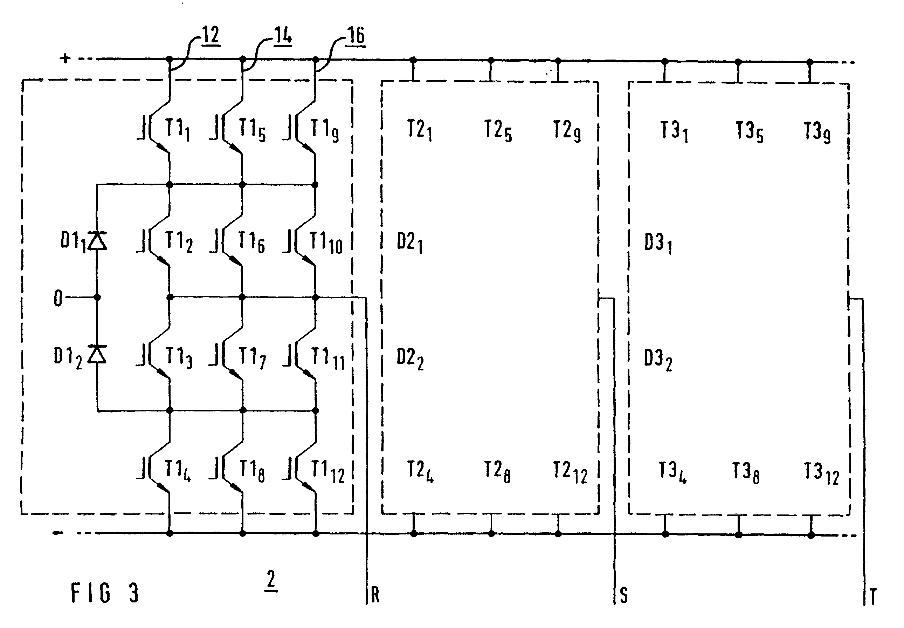

In der FIG 3 ist ein Ersatzschaltbild eines selbstgeführten Hochleistungs-Stromrichters 2 eines spannungseinprägenden Umrichters dargestellt, der als Dreipunkt-Stromrichter ausgeführt ist. Dieser Stromrichter 2 weist drei Phasen R, S und T auf, die identisch aufgebaut sind. In Abhängigkeit eines geforderten Laststromes weist jede Phase R, S und T bis zu drei Dreipunkt-Stromrichterzweige 12, 14 und 16 auf, die elektrisch parallel geschaltet sind. Als Stromrichterventile T1₁...T1₄, T1₅...T1₈ und T1₉...T1₁₂ sind jeweils IGBT-Hochleistungs-Module vorgesehen. Zur Zeit stehen IGBT-Module für 1200 A und 3300 V zur Verfügung. Die stufenweise Realisierung dieses selbstgeführten Hochleistungs-Stromrichters 2 ist in den FIG 4 bis 6 näher dargestellt.

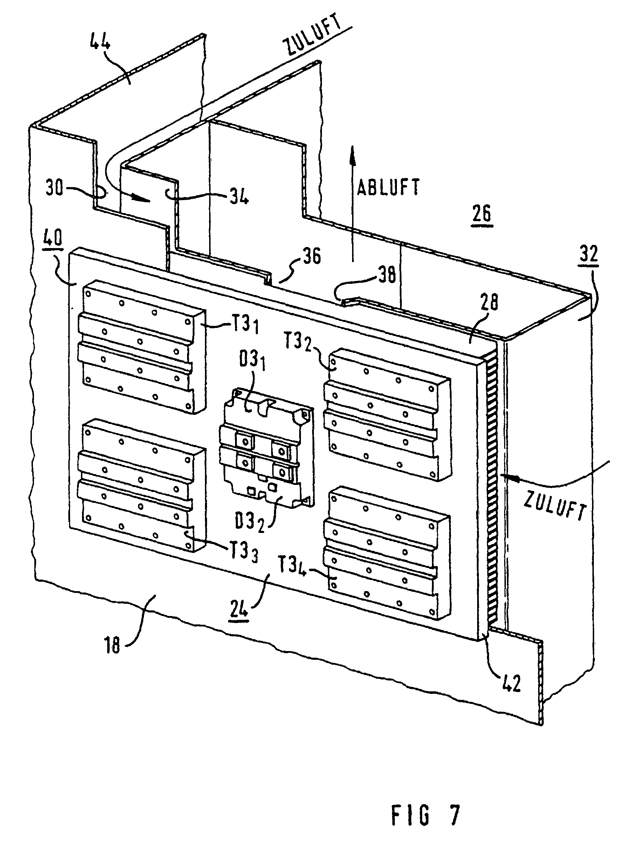

In der FIG 4 ist die Frontansicht einer Trennwand 18 des selbstgeführten Stromrichters 2 nur mit einem Dreipunkt-Stromrichterzweig 12 pro Phase R, S und T gemäß dem Ersatzschaltbild nach FIG 3 näher dargestellt. Mit dieser Trennwand 18, die drei Phasen-Kühlkörper 20, 22 und 24 aufweist, wird ein rückwärtiger Belüftungsraum 26 vom vorderen Elektronikraum abgeschottet. Die Phasen-Kühlkörper 20, 22 und 24 sind jeweils lösbar mit der Trennwand 18 verbunden. Die Kühlrippen 28 dieser Phasen-Kühlkörper 20, 22 und 24, die in dieser Darstellung nicht zu sehen sind, ragen jeweils durch eine Ausnehmung 30 der Trennwand 18 in den rückwärtigen Belüftungsraum 26 (FIG 7). Die drei Phasen-Kühlkörper 20, 22 und 24 sind übereinander angeordnet. Die Hochleistungs-Module T1₁...T1₄, T2₁...T2₄ und T3₁...T3₄ sind jeweils phasenweise mit einem Phasen-Kühlkörper 20, 22 und 24 lösbar verbunden. Mit diesen Phasen-Kühlkörpern 20, 22 und 24 sind auch die Mittelpunktsdioden D1₁, D1₂, D2₁, D2₂ und D3₁, D3₂ lösbar verbunden, wobei diese jeweils mittig zwischen den Hochleistungs-Modulen T1₁...T1₄, T2₁...T2₄ und T3₁...T3₄ angeordnet sind.

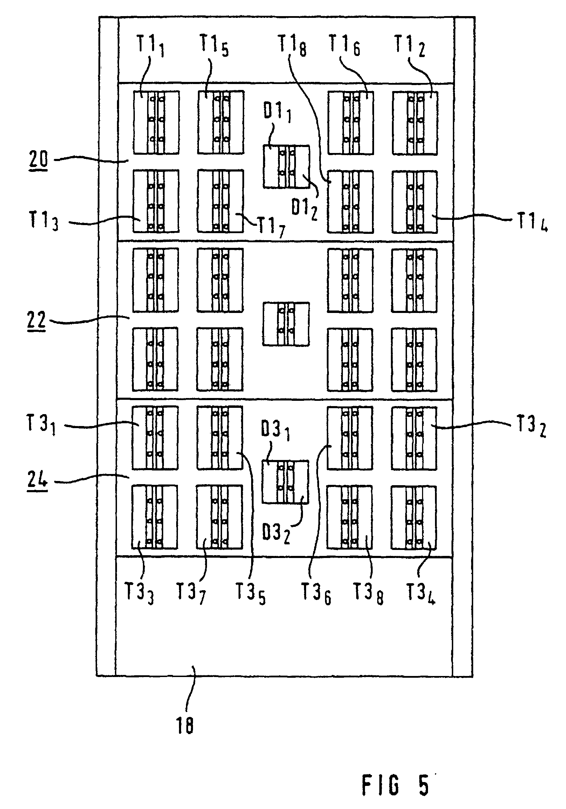

In der FIG 5 ist die Frontansicht der Trennwand 18 des selbstgeführten Stromrichters 2 mit zwei Dreipunkt-Stromrichterzweigen 12 und 14 pro Phase R, S und T gemäß dem Ersatzschaltbild nach FIG 3 näher dargestellt. Diese Ausführungsform unterscheidet sich von der Ausführungsform gemäß FIG 4 dadurch, daß jeder Phasen-Kühlkörper 20, 22 und 24 vier weitere Hochleistungs-Module T1₅...T1₈, T2₅...T2₈ und T3₅...T3₉ aufweist. Die Plazierung dieser einzelnen Hochleistungs-Module T1₁...T1₈, T2₁...T2₈ und T3₁...T3₈ auf den Phasen-Kühlkörpern 20, 22 und 24 hängt vorrangig vom Aufbau des niederinduktiven Verschienungssystems, das die beiden Zwischenkreisstromschienen und eine Mittelpunktstromschiene aufweist, ab. Durch die Erhöhung der Modulzahl ändert sich jeweils nur die Breite der Phasen-Kühlkörper 20, 22 und 24.

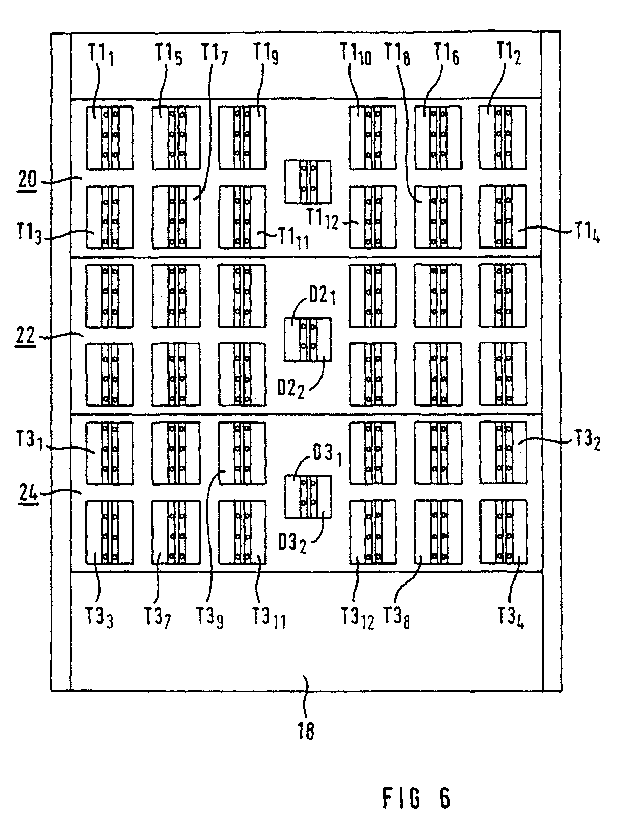

Die FIG 6 zeigt die Frontansicht der Trennwand 18 des selbstgeführten Stromrichters 2 mit drei Dreipunkt-Stromrichterzweigen 12, 14 und 16 pro Phase R, S und T gemäß dem Ersatzschaltbild nach FIG 3. Diese Ausführungsform unterscheidet sich von der Ausführungsform gemäß FIG 5 dadurch, daß jeder Phasen-Kühlkörper 20, 22 und 24 ebenfalls vier weitere Hochleistungs-Module T1₉...T1₁₂, T2₉...T2₁₂ und T3₉...T3₁₂ aufweist. Durch diese weitere Erhöhung der Modulzahl verändert sich nur die Breite jedes Phasen-Kühlkörpers 20, 22 und 24.

In der FIG 7 ist ein Ausschnitt aus dem selbstgeführten Stromrichter 2 gemäß FIG 4 näher dargestellt. In dieser Darstellung ist der im Belüftungsraum 26 angeordnete Abluftkanal 32 sichtbar. Dieser Abluftkanal 32 ist quaderförmig ausgebildet, wobei dessen Flachseite 34, die den Kühlrippen 28 der Phasen-Kühlkörper 20, 22 und 24 zugewandt ist, mittig eine Ausnehmung 36 aufweist. Die Längskanten 38 dieser Ausnehmung 36 sind jeweils aufgekantet. Die Kühlrippen 28 der Phasen-Kühlkörper 20, 22 und 24 sind im Bereich der Hochleistungs-Module T1₁...T1₄, T2₁...T2₄ und T3₁...T3₄ jeweils erhöht. Durch die Aufkanten der Längskanten 38 der Ausnehmung 36 des Abluftkanals 32 werden die der aufgekanteten Längsseiten 38 zugewandten Stirnseiten der erhöhten Kühlrippen 28 abgedeckt. Dadurch kann die Kühlluft, die jeweils beidseitig des Phasen-Kühlkörpers 20 bzw. 22 bzw. 24 zwischen den Kühlrippen 28 eintritt, nur durch die Ausnehmung 36 der Flachseite 34 des Abluftkanals 32 wieder austreten. Im Bereich dieser Ausnehmung 36 sind die Mittelpunkt-Dioden D1₁, D1₂, D2₁, D2₂ und D3₁, D3₂ einer jeden Phase R, S und T auf dem Phasen-Kühlkörper 20, 22 und 24 angeordnet.

Bei dieser Darstellung sind die Hochleistungs-Module T3₁...T3₄ gegenüber der Darstellung gemäß FIG 4 um 90° gedreht auf dem Rippengrund 40 des Phasen-Kühlkörpers 24 angeordnet. Durch diese gedrehte Anordnung der Hochleistungs-Module T3₁...T3₄ erhält man einen besonders kompakt aufgebauten Phasen-Kühlkörper 24. Werden pro Phase R, S und T mehrere Dreipunkt-Stromrichterzweige 12, 14 und 16 verwendet, so werden die Hochleistungs-Module T1₁...T1₁₂, T2₁...T2₁₂ und T3₁...T3₁₂ wie in den FIG 5 und 6 angeordnet, um einen kompakten Aufbau der Phasen-Kühlkörper 20, 22 und 24 zu erhalten. Damit die Phasen-Kühlkörper 20, 22 und 24 mit der Trennwand 18 einfach verbunden werden kann, weist jeder Rippengrund 40 der Phasen-Kühlkörper 20, 22 und 24 einen umlaufenden Rand 42 auf, mit dem sich die Phasen-Kühlkörper 20, 22 und 24 an der Trennwand 18 abstützen können. Die Ausnehmungen 30 der Trennwand 18 sind derartig zueinander angeordnet, daß sich außerdem der Phasen-Kühlkörper 22 bzw. 20 mittels seines umlaufenden Randes 42 auf den Phasen-Kühlkörper 24 bzw. 22 abstützen kann. Um eine möglichst hohe Schutzart zu erreichen, kann jeweils zwischen einem umlaufenden Rand 42 eines Phasen-Kühlkörpers 20 bzw. 22 bzw. 24 und der Trennwand 18 ein Dichtring angeordnet werden.

Durch die Verwendung des Abluftkanals 32 im Belüftungsraum 26 wird die Kühlluft aus dem Belüftungsraum 26 seitlich zwischen den Kühlrippen angesaugt und zentral in den Abluftkanal 32 ausgeblasen. Dadurch erhält jeder Phasen-Kühlkörper 20, 22 und 24 jeweils beidseitig frische Kühlluft, so daß für jedes Hochleistungs-Modul T1₁...T1₄, T2₁...T2₄ und T3₁...T3₄ dieselben Kühlbedingungen vorherrschen.

Bei einer bevorzugten Ausführungsform des selbstgeführten Stromrichters 2 sind im Belüftungsraum 26 Kühlluft-Führungskanäle 44 und 46 vorgesehen, von denen in der FIG 7 nur der Kühlluft-Führungskanal 44 dargestellt ist. Diese Kühlluft-Führungskanäle 44 und 46 sind beidseitig des Abluftkanals 32 angeordnet und verbinden rückwärtige Lufteintrittsöffnungen des Belüftungsraumes 26 mit den Stirnseiten der Kühlrippen 28 der Phasen-Kühlkörper 20, 22 und 24, die Kühlluftzuführungen darstellen. Dabei können diese Kühlluft-Führungskanäle 44 und 46 durch übereinander angeordnete Querschottwände in drei separate Luftführungskanäle unterteilt sein. Durch diese Kühlluft-Führungskanäle 44 und 46 kann die Strömungsgeschwindigkeit der Kühlluft erhöht werden, so daß die Durchflußmenge erhöht wird. Werden in jedem Kühlluft-Führungskanal 44 und 46 Querschottwände verwendet, so sind die Kühlkreisläufe der Phasen-Kühlkörper 20, 22 und 24 bezüglich der Frischluft voneinander entkoppelt.

In der Darstellung gemäß FIG 7 wird die Abluft im Abluftkanal 32 nach oben mittels wenigstens einem Lüfter abgesaugt. Diese Abluft kann auch nach unten abgesaugt werden. Es besteht auch die Möglichkeit ein Absaugen der Abluft nach hinten, wobei entlang der Breite des Abluftkanals 32 an der Rückwand mehrere kleine Lüfter angeordnet sind. Damit die Abluft aus dem Abluftkanal 32 abgesaugt werden kann, muß dieser mittels eines Verbindungskanals mit den Lüftern verbunden sein.

Durch die Zuordnung der Kühlrippen eines jeden Phasen-Kühlkörpers 20, 22 und 24 zu einem Abluftkanal 32 werden annähernd dieselben Kühlbedingungen für jedes Hochleistungs-Modul T1₁...T1₁₂, T2₁...T2₁₂ und T3₁...T3₁₂ sichergestellt. Dadurch kann die Leistungsfähigkeit der verwendeten Hochleistungs-Module T1₁...T1₁₂, T2₁...T2₁₂ und T3₁...T3₁₂ voll ausgenutzt werden. Somit wird der selbstgeführte Stromrichter 2 eines spannungseinprägenden Umrichters hinsichtlich seines Gewichtes und seiner Baugröße wesentlich verbessert, wodurch sich ebenfalls sein Wirkungsgrad verbessert und die Kosten gegenüber einem Stromrichter gleicher Leistung jedoch herkömmlicher Bauart sich verringern.

## Patentansprüche

1. Selbstgeführter Stromrichter (2) eines spannungseinprägenden Umrichters mit n Hochleistungs-Modulen (T1₁,..., T1₁₂; T2₁,..., T2₁₂; T3₁,..., T3₁₂), insbesondere IGBT-Hochleistungs-Modulen, die phasenweise jeweils mit einem Phasen-Kühlkörper (20, 22, 24) lösbar verbunden sind, die derart übereinander mit einer Trennwand (18) verbunden sind, daß deren Kühlrippen (28) durch Aussparungen (30) dieser Trennwand (18) in einem Belüftungsraum (26) ragen und jeweils waagerecht verlaufen, und wobei im Belüftungsraum (26) ein Abluftkanal (32) angeordnet ist, der derart ausgestaltet ist, daß Kühlluft des Belüftungsraums (26) jeweils beidseitig seitlich der Phasen-Kühlkörper (20, 22, 24) zwischen deren Kühlrippen (28) in den Abluftkanal (32) strömt, aus der diese mittels eines Lüfters abgesaugt wird.

2. Selbstgeführter Stromrichter (2) nach Anspruch 1, wobei die Hochleistungs-Module (T1₁,..., T1₁₂; T2₁,..., T2₁₂; T3₁,..., T3₁₂) eines Phasen-Kühlkörpers (20, 22, 24) jeweils entlang seiner Kühlluftzuführungen nebeneinander angeordnet sind.

3. Selbstgeführter Stromrichter (2) nach Anspruch 1, wobei die Hochleistungs-Module (T1₁,..., T1₁₂; T2₁,..., T2₁₂; T3₁,..., T3₁₂) eines Phasen-Kühlkörpers (20, 22, 24) jeweils entlang der Kühlluftwege nebeneinander angeordnet sind.

4. Selbstgeführter Stromrichter (2) nach Anspruch 1, wobei die Hochleistungs-Module (T1₁,..., T1₁₂; T2₁,..., T2₁₂; T3₁,..., T3₁₂) eines Phasen-Kühlkörpers (20, 22, 24) jeweils entlang der Kühlluftzuführungen und entlang der Kühlluftwege nebeneinander angeordnet sind.

5. Selbstgeführter Stromrichter (2) nach einem der vorgenannten Ansprüche 1 bis 4, wobei die Kühlrippen (28) der Phasen-Kühlkörper (20, 22, 24) jeweils im Bereich der Hochleistungs-Module (T1₁,..., T1₁₂; T2₁,..., T2₁₂; T3₁,..., T3₁₂) erhöht sind.

6. Selbstgeführter Stromrichter (2) nach Anspruch 1, wobei ein Rippengrund (40) eines Phasen-Kühlkörpers (20, 22, 24) mit einem umlaufenden Rand (42) versehen ist.

7. Selbstgeführter Stromrichter (2) nach Anspruch 1, wobei der Abluftkanal (32) quaderförmig ausgebildet ist, dessen den Kühlrippen (28) der Phasen-Kühlkörper (20, 22, 24) zugewandte Flachseite (34) mittig eine Ausnehmung (36) aufweist.

8. Selbstgeführter Stromrichter (2) nach Anspruch 5 und 7, wobei die Längskanten (38) der Ausnehmung (36) der Flachseite (34) des Abluftkanals (32) aufgekantet sind.

9. Selbstgeführter Stromrichter (2) nach Anspruch 1, wobei der Belüftungsraum (26) Kühlluft-Führungskanäle (44, 46) aufweist, die Lufteintrittsöffnungen des Belüftungsraumes (26) mit den Kühlluftzuführungen der Phasen-Kühlkörper (20, 22, 24) verbindet.

10. Selbstgeführter Stromrichter (2) nach Anspruch 1, wobei zwischen der Trennwand (18) und jeweils einem Phasen-Kühlkörper (20, 22, 24) ein Dichtring angeordnet ist.

## Claims

1. Self-commutated power converter (2) of a voltage-impressing converter having n high-power modules (T1₁,..., T1₁₂; T2₁,..., T2₁₂; T3₁,..., T3₁₂), in particular IGBT high-power modules, which are joined phasewise to a phase heat sink (20, 22, 24), respectively, in a detachable manner, the phase heat sinks being joined, one over another, to a partition (18) such that their cooling fins (28) protrude through openings (30) of this partition (18) into a ventilation space (26) and each run horizontally, and an air-discharge duct (32) being arranged in the ventilation space (26), the air-discharge duct being designed such that cooling air of the ventilation space (26) flows laterally, in each case on both sides of the phase heat sinks (20, 22, 24) between their cooling fins (28) into the air-discharge duct (32), from where it is sucked out by a fan.

2. Self-commutated power converter (2) according to Claim 1, whereby the high-power modules (T1₁,..., T1₁₂; T2₁,..., T2₁₂; T3₁,..., T3₁₂) of a phase heat sink (20, 22, 24) are each arranged side by side along the cooling-air supplies of the phase heat sink.

3. Self-commutated power converter (2) according to Claim 1, whereby the high-power modules (T1₁,..., T1₁₂; T2₁,..., T2₁₂; T3₁,..., T3₁₂) of a phase heat sink (20, 22, 24) are each arranged side by side along the cooling-air passages.

4. Self-commutated power converter (2) according to Claim 1, whereby the high-power modules (T1₁,..., T1₁₂; T2₁,..., T2₁₂; T3₁,..., T3₁₂) of a phase heat sink (20, 22, 24) are each arranged side by side along the cooling-air supplies and along the cooling-air passages.

5. Self-commutated power converter (2) according to one of the preceding Claims 1 to 4, whereby the cooling fins (28) of the phase heat sinks (20, 22, 24) are each raised in the region of the high-power modules (T1₁,..., T1₁₂; T2₁,..., T2₁₂; T3₁,..., T3₁₂).

6. Self-commutated power converter (2) according to Claim 1, whereby a fin base (40) of a phase heat sink (20, 22, 24) is provided with a surrounding rim (42).

7. Self-commutated power converter (2) according to Claim 1, whereby the air-discharge duct (32) has a cuboidal design, its large face (34), which faces the cooling fins (28) of the phase heat sinks (20, 22, 24), having a centrical opening (36).

8. Self-commutated power converter (2) according to Claims 5 and 7, whereby the longitudinal edges (38) of the opening (36) of the large face (34) of the air-discharge duct (32) are folded up.

9. Self-commutated power converter (2) according to Claim 1, whereby the ventilation space (26) has cooling-air guide ducts (44, 46) connecting the air-inlet openings of the ventilation space (26) to the cooling-air supplies of the phase heat sinks (20, 22, 24).

10. Self-commutated power converter (2) according to Claim 1, whereby a sealing ring is arranged between the partition (18) and in each case one phase heat sink (20, 22, 24).

## Revendications

1. Convertisseur autocommuté (2) d'un changeur de fréquence appliquant une tension, comportant n modules de grande puissance (T1₁ à T1₁₂ ; T2₁ à T2₁₂ ; T3₁ à T3₁₂), notamment des modules de grande puissance IGBT, qui sont assemblés, amovibles, pour chaque phase respectivement à un corps de refroidissement de phase (20, 22, 24), lesquels corps de refroidissement de phase sont assemblés les uns au-dessus des autres à une paroi séparatrice (18) de telle sorte que leurs nervures de refroidissement (28) entrent par des évidements (30) de cette paroi séparatrice (18) dans un espace d'aération (26) et s'étendent respectivement horizontalement, un canal d'air d'évacuation (32) étant disposé dans l'espace d'aération (26) et étant conçu de telle sorte que de l'air de refroidissement de l'espace d'aération (26) s'écoule respectivement des deux côtés des corps de refroidissement de phase (20, 22, 24) entre leurs nervures de refroidissement (28) vers le canal d'air d'évacuation (32) hors duquel il est aspiré au moyen d'un ventilateur.

2. Convertisseur autocommuté (2) selon la revendication 1, dans lequel les modules de grande puissance (T1₁ à T1₁₂ ; T2₁ à T2₁₂ ; T3₁ à T3₁₂) d'un corps de refroidissement de phase (20, 22, 24) sont disposés les uns à côté des autres le long de ses amenées d'air de refroidissement.

3. Convertisseur autocommuté (2) selon la revendication 1, dans lequel les modules de grande puissance (T1₁ à T1₁₂ ; T2₁ à T2₁₂ ; T3₁ à T3₁₂) d'un corps de refroidissement de phase (20, 22, 24) sont disposés les uns à côté des autres le long des trajets d'air de refroidissement.

4. Convertisseur autocommuté (2) selon la revendication 1, dans lequel les modules de grande puissance (T1₁ à T1₁₂ ; T2₁ à T2₁₂ ; T3₁ à T3₁₂) d'un corps de refroidissement de phase (20, 22, 24) sont disposés les uns à côté des autres le long des amenées d'air de refroidissement et le long des trajets d'air de refroidissement.

5. Convertisseur autocommuté (2) selon l'une des revendications précédentes 1 à 4, dans lequel les nervures de refroidissement (28) des corps de refroidissement de phase (20, 22, 24) sont surélevées dans la zone des modules de grande puissance (T1₁ à T1₁₂ ; T2₁ à T2₁₂ ; T3₁ à T3₁₂).

6. Convertisseur autocommuté (2) selon la revendication 1, dans lequel un fond de nervure (40) d'un corps de refroidissement de phase (20, 22, 24) est muni d'un bord (42) qui en fait le tour.

7. Convertisseur autocommuté (2) selon la revendication 1, dans lequel le canal d'air d'évacuation (32) est parallélépipédique et son côté plat (34) proche des nervures de refroidissement (28) des corps de refroidissement de phase (20, 22, 24) comporte un évidement (36) au centre.

8. Convertisseur autocommuté (2) selon les revendications 5 et 7, dans lequel les arêtes longues (38) de l'évidement (36) du côté plat (34) du canal d'air d'évacuation (32) sont posées de chant.

9. Convertisseur autocommuté (2) selon la revendication 1, dans lequel l'espace d'aération (26) comporte des canaux de conduite d'air de refroidissement (44, 46) qui relie des ouvertures d'entrée d'air de l'espace d'aération (26) aux amenées d'air de refroidissement des corps de refroidissement de phase (20, 22, 24).

10. Convertisseur autocommuté (2) selon la revendication 1, dans lequel un anneau d'étanchéité est placé entre la paroi séparatrice (18) et à chaque fois un corps de refroidissement de phase (20, 22, 24).
